# EUROPEAN PATENT APPLICATION

(11) **EP 4 746 109 A1**
(43) Date of publication of application: **20.05.2026**
(21) Application number: 25215640.1
(22) Date of filing: 13.11.2025
(51) Int. Cl.: H01M 10/42, H05K 1/16, H05K 1/18

(54) **PROTECTION CIRCUIT MODULE AND BATTERY PACK**

(30) Priority: 15.11.2024 KR 20240163158
(71) Applicant: SAMSUNG SDI CO., LTD., Yongin-si, Gyeonggi-do 17084 (KR)
(72) Inventor: YOON, Joon Gu, 16678 Suwon-si (KR)
(74) Representative: Maiwald GmbH

(57) **Abstract**

Embodiments of the present disclosure relates to a protection circuit module, and the technical problem to be solved is to provide a protection circuit module capable of dissipating heat. To this end, embodiments of the present disclosure provides a protection circuit module including a substrate, a circuit pattern disposed on the substrate, and an insulating layer provided on the substrate while covering the circuit pattern, wherein the insulating layer includes one or more holes formed on at least a portion of the circuit pattern.

## Description

### FIELD

The present disclosure relates to a protection circuit module and a battery pack including the protection circuit module.

### BACKGROUND

Generally, the demand for secondary batteries with high energy density and high capacity is rapidly increasing with the rapid spread of electronic devices using batteries, such as mobile phones, notebook computers, electric vehicles, and the like. Accordingly, research and development for improving performance of lithium secondary batteries is being actively conducted.

A lithium secondary battery is a battery including a positive electrode and a negative electrode including active materials capable of intercalating and deintercalating lithium ions, and an electrolyte, and produces electrical energy due to oxidation and reduction reactions when lithium ions are intercalated/deintercalated into/from the positive electrode and the negative electrode.

The herein-described information disclosed in the background technology of the present disclosure is only for improving understanding of the background of the present disclosure, and accordingly, may include information that does not constitute the related art.

### SUMMARY

Embodiments of the present disclosure are directed to providing a protection circuit module capable of dissipating heat and/or a battery pack including the protection circuit module.

For example, embodiments of the present disclosure may dissipate heat generated from a circuit pattern provided in the protection circuit module to the outside.

Embodiments of the present disclosure are directed to providing a protection circuit module capable of dissipating heat without adding separate components for dissipating heat and/or a battery pack including the protection circuit module.

However, technical problems to be solved by the present disclosure are not limited to the herein-described problems, and other problems which are not mentioned, will be clearly understood by those skilled in the art from the description of the disclosure disclosed herein.

A protection circuit module according to the present disclosure for solving the herein technical problem includes: a substrate; a circuit pattern disposed on the substrate; and an insulating layer provided on the substrate while covering the circuit pattern, wherein the insulating layer includes one or more holes formed on at least a portion of the circuit pattern.

A battery pack according to the present disclosure for solving the herein technical problem includes: a plurality of secondary batteries; and a protection circuit module disposed on one side of the plurality of secondary batteries and electrically connected to the plurality of secondary batteries, wherein the protection circuit module includes: a substrate; a circuit pattern disposed on the substrate; and an insulating layer provided on the substrate while covering the circuit pattern, and the insulating layer includes one or more holes formed on at least a portion of the circuit pattern.

### BRIEF DESCRIPTION OF THE DRAWINGS

Since the following drawings appended in the present specification exemplify preferred embodiments of the present disclosure, and serve to help further understanding of the technical spirit of the present disclosure together with the following detailed description of the disclosure, the present disclosure should not be understood as being limited to the items disclosed in the drawings, in which:
FIG. 1 is a perspective view schematically illustrating a configuration of a battery pack according to embodiments of the present disclosure;
FIG. 2 is a perspective view schematically illustrating a configuration of a battery pack according to embodiments of the present disclosure;
FIG. 3 is a view schematically illustrating a configuration of a protection circuit module according to embodiments of the present disclosure;
FIG. 4 is a top view schematically illustrating the configuration of the protection circuit module according to embodiments of the present disclosure;
FIG. 5 is a top view schematically illustrating a protection circuit module according to embodiments of the present disclosure;
FIG. 6 is a cross-sectional view of the protection circuit module according to embodiments of the present disclosure taken along line A-A' shown in FIG. 5;
FIG. 7 is a cross-sectional view of the protection circuit module according to embodiments of the present disclosure taken along line A-A' shown in FIG. 5;
FIG. 8 is a cross-sectional view of the protection circuit module according to embodiments of the present disclosure taken along line A-A' shown in FIG. 5;
FIG. 9 is a top view schematically illustrating a protection circuit module according to embodiments of the present disclosure;
FIG. 10 is a cross-sectional view of the protection circuit module according to embodiments of the present disclosure taken along line B-B' shown in FIG. 9;
FIG. 11 is a top view schematically illustrating a protection circuit module according to embodiments of the present disclosure;
FIG. 12 is a cross-sectional view of the protection circuit module according to embodiments of the present disclosure taken along line C-C' shown in FIG. 11;
FIG. 13 is a cross-sectional view of the protection circuit module according to embodiments of the present disclosure taken along line C-C' shown in FIG. 11; and
FIG. 14 is a cross-sectional view of a protection circuit module according to embodiments of the present disclosure.

### DETAILED DESCRIPTION

Hereinafter, preferable embodiments of the present disclosure will be described in detail with reference to the accompanying drawings. Prior to this, the terms and words used in the present specification and claims should not be construed as being limited to their usual or dictionary meanings, and should be interpreted as meanings and concepts consistent with the proposed technical spirit of the present disclosure based on the principle that the inventor may appropriately define the concept of terms to describe his/her disclosure in the best way.

Further, when used in the present specification, "comprise or include" and/or "comprising or including" specify the presence of mentioned shapes, numbers, steps, operations, members, elements and/or groups thereof, and do not exclude the presence or addition of one or more other shapes, numbers, steps, operations, members, elements and/or groups thereof.

Further, in order to help understanding of the disclosure, the accompanying drawings are not drawn to actual scale and the sizes of some components may be exaggerated. In addition, the same reference numerals may be given to the same components in different embodiments.

The mention that two objects to be compared are 'the same' means that that the two objects are 'substantially the same.' Accordingly, 'substantially the same' may include a deviation considered as a low level in the art, for example, a deviation within 5%. Further, uniformity of a parameter in a certain region may mean uniformity from an average point of view.

Although first, second, and the like are used to describe various components, these components are not limited by these terms. These terms are only used to distinguish one component from another component, and a first component may also be a second component unless otherwise stated.

Throughout the specification, unless otherwise stated, each component may be singular or plural.

When an arbitrary configuration is placed "on (or under)" a component or "above (or below)" a component, it can mean not only that the arbitrary configuration is placed in contact with the top (or bottom) of the component, but also that other configurations can be interposed between the component and the arbitrary configuration placed on (or under) the component.

Further, when it is disclosed that a certain component is "on," "connected to," or "coupled to" another component, it should be understood that the components may be directly connected or linked to each other, but another component may be "interposed" between the components, or the components may be "connected," "coupled," or "linked" through another component.

As used in the present specification, the term "and/or" includes any one or more and all combinations of the related listed items. Further, when embodiments of the present disclosure are described, the use of "may" relates to "one or more embodiments of the present disclosure." The term such as "one or more" before a list of elements modifies an entire list of the elements and does not modify individual elements in the list.

Throughout the specification, "A and/or B" means to A, B, or A and B unless otherwise stated, and "C to D" means greater than or equal to C and less than or equal to D unless otherwise specified.

When phrases such as "at least one of A, B, and C," "at least one of A, B, or C," "at least one selected from group A, B, and C," or "at least one selected from A, B, and C" are used to specify a list of elements A, B, and C, the phrases may refer to any one of all suitable combinations.

The term "use" may be considered to be synonymous with the term "utilize." As used in the present specification, the terms "substantially," "about," and other similar terms are used as terms of approximation rather than terms of degrees, and are intended to consider an inherent variation in measured or calculated values to be recognized by those skilled in the art.

Although the terms "first," "second," "third," and the like may be used in the present specification to describe various elements, components, regions, layers and/or sections, these elements, components, regions, layers and/or sections should not be limited by these terms. These terms are used only to distinguish one element, component, region, drawing layer, or section from another element, component, region, drawing layer, or section. Accordingly, a first element, component, region, layer, or section to be described herein may be referred to a second element, component, region, layer, or section without departing from the teachings of the present disclosure.

Spatially related terms such as "beneath," "below," "lower," "above," and "upper" are used for easy description of the relationship of one element or feature to another element or feature shown in the drawings. These spatially related terms are provided for easy understanding of the present disclosure according to various process states or usage states of the present disclosure, and are not intended to limit the present disclosure. For example, when the elements or features in the drawings are reversed, an element described as "lower" or "below" "becomes "upper" or "above." Accordingly, "below" is a concept encompassing "above" or "below."

The terms used in the present specification is intended to describe the embodiments of the present disclosure, and is not intended to limit the present disclosure.

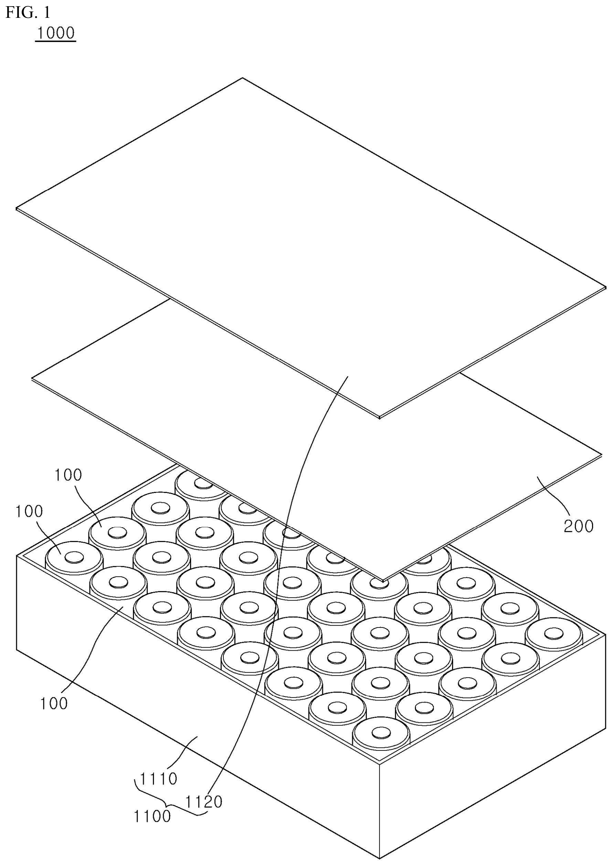

FIG. 1 is a perspective view schematically illustrating a configuration of a battery pack according to embodiments of the present disclosure.

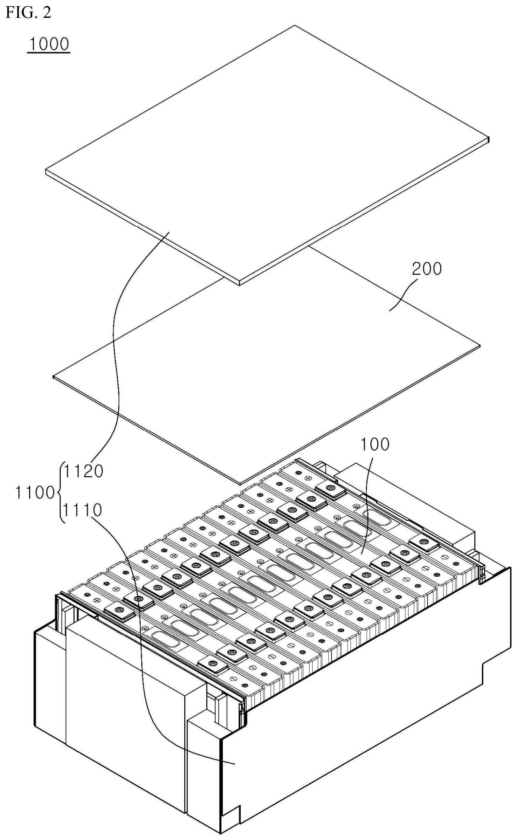

FIG. 2 is a perspective view schematically illustrating a configuration of a battery pack according to embodiments of the present disclosure.

A battery pack 1000 according to various embodiments may include a housing 1100, a secondary battery 100, and a protection circuit module 200. FIG 1 illustrates a battery pack 1000 including, for example, a cylindrical secondary battery 100. FIG. 2 illustrates a battery pack 1000 including, for example, a prismatic secondary battery 100.

The housing 1100 may form an approximate exterior of the battery pack 1000 and may provide space in which a secondary battery 100 may be accommodated.

The housing 1100 according to the present embodiment may include a housing body 1110 and a cover 1120.

The housing body 1110 may be formed to have a shape of a box with an empty interior and one open side. A cross-sectional shape of the housing body 1110 is not limited to the quadrangular shape shown in FIG. 1, and may be designed to have various shapes such as a polygonal shape, a circular shape, an oval shape, and the like.

The cover 1120 may be coupled to the housing body 1110 and may close an inner space of the housing body 1110. For example, the cover 1120 may be formed to have a substantially plate shape and may be disposed to face the open side of the housing body 1110. The cover 1120 may be fixed to the housing body 1110 by various types of coupling methods such as welding, bolting, fitting, and the like.

The secondary battery 100 may function as a unit structure which stores and supplies power in the battery pack.

A plurality of secondary batteries 100 may be provided. The plurality of secondary batteries 100 may be disposed to form various patterns such as a grid shape, a zigzag shape, and the like in the housing 1100. The plurality of secondary batteries 100 may be disposed in parallel. The number of secondary batteries 100 may be designed in various ways depending on the size, shape and the like of the housing 1100. The detailed configurations of the secondary battery will be described herein.

The protection circuit module 200 may protect the battery pack 1000 or manage and/or control one or more components included in the battery pack 1000.

For example, the protection circuit module 200 performs functions such as overcharging protection, overdischarging protection, overcurrent protection, short circuit protection, or the like of the secondary battery 100. Alternatively, for example, the protection circuit module 200 transmits and receives and/or controls information of the secondary battery 100 through wired or wireless communication. Alternatively, for example, the protection circuit module 200 may monitor information of the secondary battery 100. Alternatively, for example, the protection circuit module 200 may calculate information about the secondary battery 100 such as a remaining capacity, a charge/discharge history, a total amount of energy, or the like of the secondary battery 100. Alternatively, for example, the protection circuit module 200 may reduce and uniformly maintain a voltage difference between the secondary batteries 100.

The protection circuit module 200 may include, for example, a battery management system (BMS), a protection circuit module (PCM), and the like.

Although not shown, the battery pack 1000 may further include a bus bar located between the secondary battery 100 and the protection circuit module 200. The bus bar may electrically connect the plurality of secondary batteries 100. For example, the plurality of secondary batteries 100 may be connected in series and/or parallel by the bus bar. For example, the bus bar may connect secondary batteries 100 disposed in the same row in of the housing 1100 in parallel and connect secondary batteries 100 disposed in two adjacent rows in series. The bus bar may be formed of an electrically conductive material such as copper, aluminum, nickel, or the like.

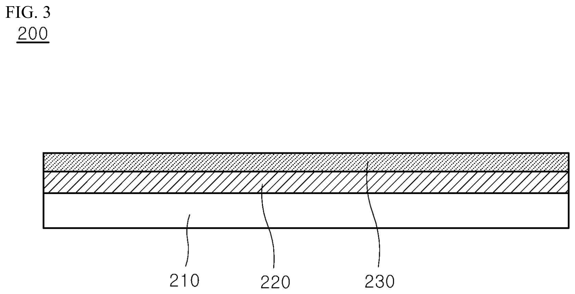

FIG. 3 is a view schematically illustrating a configuration of the protection circuit module according to embodiments of the present disclosure.

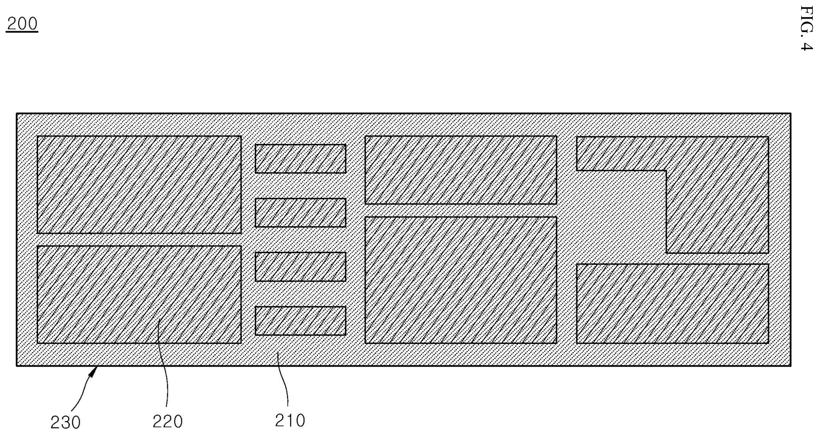

FIG. 4 is a top view schematically illustrating the configuration of the protection circuit module according to embodiments of the present disclosure.

FIGS. 3 and 4 describe the protection circuit module 200 according to embodiments of the present disclosure described in FIGS. 1 and 2 in detail. FIG. 3 is a view of the protection circuit module 200 viewed from one side surface, and FIG. 4 is a view of the protection circuit module 200 viewed from above.

For example, the protection circuit module 200 according to embodiments of the present disclosure controls the secondary battery 100 to perform charging and discharging. For example, the protection circuit module 200 may perform communication with the outside. For example, the protection circuit module 200 may include a protection circuit unit to ensure the stability of the secondary battery 100. To this end, at least a portion of the protection circuit module 200 may be electrically connected to the secondary battery 100.

The protection circuit module 200 includes a substrate 210, a circuit pattern 220, and an insulating layer 230. However, the components included in the protection circuit module 200 are not limited thereto, and in the protection circuit module 200, a part of the components shown in FIG. 3 may be omitted or more components may be included.

As shown in FIG. 3, the protection circuit module 200 may be formed by stacking all or part of the components. For example, the protection circuit module 200 includes the substrate 210, the circuit pattern 220 disposed on at least a portion of the substrate 210, and the insulating layer 230 located on at least a portion of the circuit pattern 220.

The substrate 210 supports an overall shape of the protection circuit module 200. The substrate 210 is formed with an exterior which allows the protection circuit module 200 to be inserted into an opening of the housing 1100 and located on the plurality of secondary batteries 100.

For example, the substrate 210 is formed in a polygonal shape when viewed from above. For example, as shown in FIG. 4, the substrate 210 may be formed in a rectangular shape when viewed from above. In this case, the substrate 210 includes a pair of long sides and a pair of short sides when viewed from above. The pair of long sides are formed to have relatively long edges and are disposed to face each other. The pair of short sides are formed to have relatively short edges and connect the pair of long sides while facing each other. However, the shape of the substrate 210 is not limited thereto, and the shape of the substrate 210 may be set depending on, for example, the opening of the housing 1100 and/or the disposition structure of the plurality of secondary batteries 100.

The substrate 210 provides a space where the circuit pattern 220 is printed. For example, the substrate 210 may include a non-conductive material. For example, the substrate 210 may include an epoxy resin, a bakelite resin, polyimide (PI), or the like as an insulator. For example, the substrate 210 may electrically insulate the circuit pattern 220 from unintended components. Accordingly, the substrate 210 may electrically connect the circuit pattern 220 provided on the substrate 210 to intended components.

Although not shown, the substrate 210 may further include a terminal hole formed through the substrate 210. The protection circuit module 200 provides a path which may be electrically connected to the secondary battery through a via hole. Alternatively, all or part of the components included in the protection circuit module 200 may be electrically connected to each other through the via hole.

The circuit pattern 220 is disposed on the substrate 210. For example, the circuit pattern 220 may be formed by being printed on the substrate 210. Alternatively, for example, the circuit pattern 220 may be formed through an operation of exposing or etching a copper clad laminate in which a copper foil is laminated on at least one surface of the substrate 210. FIGS. 3 and 4 illustrate an example in which the circuit pattern 220 is disposed on one surface of the substrate 210, but the circuit pattern 220 according to embodiments of the present disclosure is not limited thereto. For example, the circuit pattern 220 may be disposed on one surface or both surfaces of the substrate 210.

The circuit pattern 220 electrically connects the components included in the protection circuit module 200. Alternatively, the circuit pattern 220 electrically connects the protection circuit module 200, the secondary battery 100, and/or external components. In this case, the circuit pattern 220 may electrically connect each component through a via hole as necessary.

For example, the circuit pattern 220 includes a metal line, a protection circuit element, and/or an electrode terminal. For example, the protection circuit element may include a passive element such as a resistor or a capacitor, or an active element such as a field effect transistor (FET). Further, the circuit pattern 220 may further include, for example, a temperature sensor, a fuse, and the like. For example, the temperature sensor may include a positive temperature coefficient thermistor, a negative temperature coefficient thermistor, and the like. For example, the fuse may disconnect the electrical flow to the secondary battery 100 by melting when an overcurrent occurs due to overcharging, overdischarging, an external short circuit, and/or the like.

Meanwhile, the circuit pattern 220 shown in FIG. 4 is exemplified for convenience of description. The disposition of the circuit pattern 220 is not limited to the contents shown in FIG. 4.

The insulating layer 230 is provided on the substrate 210 while covering a portion of the circuit pattern 220. The insulating layer 230 includes an insulating material. For example, the insulating material includes a photo solder resist (PSR) insulating ink. However, examples of the insulating material are not limited thereto, and the insulating material described through embodiments of the present disclosure includes all materials capable of insulating electricity. Accordingly, the insulating layer 230 protects the circuit pattern 220 and/or prevents a short circuit from occurring in the circuit pattern 220.

Meanwhile, as the battery pack 1000 and/or the protection circuit module 200 are driven, the circuit pattern 220 may generate heat. In order to discharge the heat generated from the circuit pattern 220 to the outside, the insulating layer 230 may not cover at least a portion of the circuit pattern 220.

For example, the insulating layer 230 is provided on the substrate 210 while covering a portion of an upper portion and an entire side of the circuit pattern 220. Alternatively, for example, the insulating layer 230 is provided on the substrate 210 while covering an entire upper portion and a portion of the side of the circuit pattern 220. Alternatively, for example, the insulating layer 230 is provided on the substrate 210 while covering a portion of the upper portion and a portion of the side of the circuit pattern 220. Accordingly, the insulating layer 230 may expose a portion of the circuit pattern 220 that is not covered by the insulating layer 230 to the outside.

Through this configuration, the protection circuit module 200 according to embodiments of the present disclosure may effectively perform heat dissipation without adding separate components for dissipating heat. Further, the protection circuit module 200 may allow a maximum temperature of the battery pack 1000 to be reduced.

Hereinafter, the protection circuit module 200 having the heat dissipation effect will be described in detail through various examples.

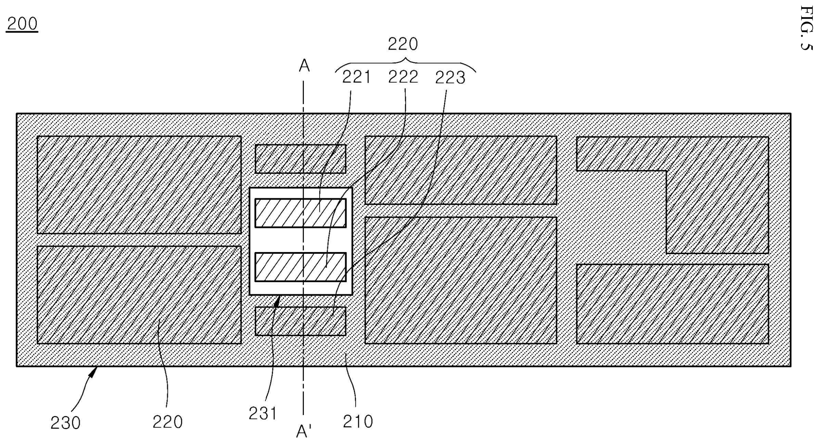

FIG. 5 is a top view schematically illustrating a protection circuit module according to embodiments of the present disclosure.

As described in FIGS. 1 to 4, the protection circuit module 200 may protect and/or control all or part of the components included in the battery pack 1000. For example, the protection circuit module 200 may control the charging and discharging of the secondary battery 100 and may detect and/or prevent the overcharging and/or overdischarging of the secondary battery 100.

A protection circuit module 200 (for example, including the protection circuit module described in FIGS. 1 to 4) includes a substrate 210, a circuit pattern 220 disposed on the substrate 210, and an insulating layer 230 disposed on the substrate 210 while covering the circuit pattern 220, and the insulating layer 230 includes one or more holes 231 formed on at least a portion of the circuit pattern 220.

A battery pack 1000 according to embodiments of the present disclosure (for example, including the battery pack described in FIGS. 1 and 2) includes a plurality of secondary batteries 100, and a protection circuit module 200 disposed on one side of the plurality of secondary batteries 100 and electrically connected to the plurality of secondary batteries 100, wherein the protection circuit module 200 includes a substrate 210, a circuit pattern 220 disposed on the substrate 210, and an insulating layer 230 disposed on the substrate 210 while covering the circuit pattern 220, and the insulating layer 230 includes one or more holes 231 formed on at least a portion of the circuit pattern 220.

As described in FIGS. 3 and 4, the insulating layer 230 includes a hole 231 which exposes at least a portion of the circuit pattern 220.

For example, the insulating layer 230 is applied to a portion of the substrate 210 where the circuit pattern 220 is disposed. Alternatively, the insulating layer 230 is coated on a portion of the substrate 210 where the circuit pattern 220 is disposed.

In this case, the insulating layer 230 includes a region which is not applied or coated on the substrate 210. The hole 231 represents a region where the insulating layer 230 is not applied or coated. The hole 231 exposes an upper portion of the portion of the circuit pattern 220.

Accordingly, a portion of the circuit pattern 220 may be exposed through the hole 231 and the other portion of the circuit pattern 220 may be covered by the insulating layer 230.

For example, the hole 231 is formed on a heating pattern which generates more than a certain amount of heat per unit time in the circuit pattern 220. In this case, the certain amount of heat per unit time may be set in consideration of the material/thickness of the insulating layer 230, the material/thickness of the housing 1100, the capacity/size of the battery pack 1000, the capacity/size of the secondary battery 100, and the like.

For example, heating patterns (for example, 221 and 222) may include at least one of a field effect transistor (FET), a synchronous rectifier (SR), a resistor, a capacitor, and a transistor. Alternatively, for example, the heating patterns (for example, 221 and 222) may include a high current pattern formed along a power line through which a high current flows. Alternatively, for example, the heating patterns (for example, 221 and 222) may include a pattern which is electrically connected to the high current pattern and generates heat by a resistance component of the pattern. However, the heating patterns (for example, 221 and 222) according to embodiments of the present disclosure are not limited thereto, and the heating patterns (for example, 221 and 222) includes all patterns which are electrically connected and discharge heat per unit time.

For example, as shown in FIG. 5, the circuit pattern 220 may include the heating patterns (for example, 221 and 222) and a normal pattern (for example, 223). In this case, the normal pattern (for example, 223) represents a circuit pattern which generates less than a certain amount of heat per unit time.

The hole 231 is formed on the heating patterns (for example, 221 and 222) to expose the heating patterns (for example, 221 and 222). Accordingly, when viewed from above, the heating patterns (for example, 221 and 222) are exposed by the hole 231.

For example, as shown in FIG. 5, the hole 231 may completely expose one heating pattern (for example, 221 or 222). Accordingly, the insulating layer 230 may efficiently discharge the heat generated from the circuit pattern 220 through the hole 231.

However, unlike as shown in FIG. 5, the hole 231 may also expose at least a portion of one heating pattern (for example, 221 or 222).

For example, the heating patterns include a first heating pattern 221 and a second heating pattern 222. In this case, for example, a heat generation amount of the second heating pattern 222 may be greater than that of the first heating pattern 221.

For example, the hole 231 may be formed on a portion of the first heating pattern 221. That is, the portion of the first heating pattern 221 may be exposed to the outside by the hole 231 and the other portion of the first heating pattern 221 may be covered by the insulating layer 230. Thus, the hole 231 may simultaneously perform insulation and/or heat dissipation of the circuit pattern 220 by exposing only a portion of the circuit pattern 220 having a relatively small heat generation amount.

For example, the hole 231 may be formed on the entire second heating pattern 222. That is, the entire second heating pattern 222 may be exposed to the outside by the hole 231. Thus, the hole 231 may enhance the heat dissipation efficiency of the circuit pattern 220 by exposing the entire circuit pattern 220 having a relatively large heat generation amount.

Alternatively, for example, unlike as shown in FIG. 5, the hole 231 may be formed on only a part of the plurality of heating patterns (for example, 221 and 222). For example, the hole 231 is not formed on the first heating pattern 221 and may be formed on the second heating pattern 222. In this case, the hole 231 may be formed so that the entire second heating pattern 222 is exposed or may also be formed so that only a portion of the second heating pattern 222 is exposed.

For example, the heating patterns (for example, 221 and 222) may include a field effect transistor (FET) and a high current pattern disposed adjacent to each other. In this case, the hole 231 may be formed while exposing each of the FET and the high current pattern. Accordingly, the hole 231 may allow heat generated from the FET and the high current pattern to be directly discharged. Alternatively, the hole 231 is not formed on the FET and may be formed only on the high current pattern to expose only the high current pattern. Accordingly, the hole 231 allows the heat generated from the high current pattern to be directly discharged. Further, the hole 231 allows the heat generated from the FET to be thermally diffused through convection.

Thus, the insulating layer 230 may include a hole 231 whose position and/or size are/is set by predicting the heat generation amount of the heating patterns (for example, 221 and 222).

Further, the insulating layer 230 is formed on the substrate 210 while covering the entire normal pattern 223. Thus, the insulating layer 230 may help insulation of the circuit pattern 220 by insulating the entire circuit pattern 220 having a negligible heat generation amount.

Alternatively, for example, unlike as shown in FIG. 5, the circuit pattern 220 may include only the heating patterns (for example, 221 and 222). In this case, the hole 231 may be formed on all of the heating patterns (for example, 221 and 222). Alternatively, the hole 231 may be formed on portions of the heating patterns (for example, 221 and 222). Thus, the protection circuit module 200 according to embodiments of the present disclosure may have a heat dissipation structure through the hole 231 formed on at least a portion of the insulating layer 230. Further, the protection circuit module 200 may prevent heat from accumulating on the protection circuit module 200 through the holes 231. Further, the battery pack 1000 may reduce a maximum temperature when heat is generated by the protection circuit module 200.

Hereinafter, various examples of the hole 231 will be described.

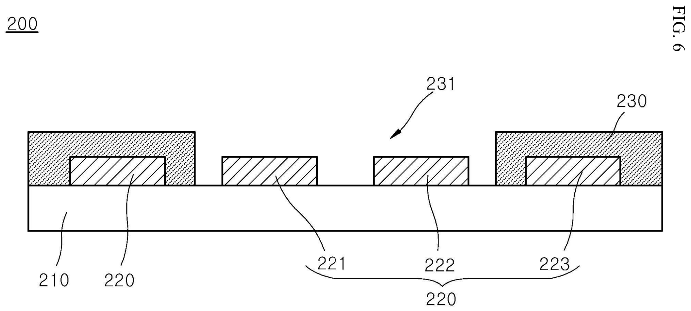

FIG. 6 is a cross-sectional view of the protection circuit module according to embodiments of the present disclosure taken along line A-A' shown in FIG. 5.

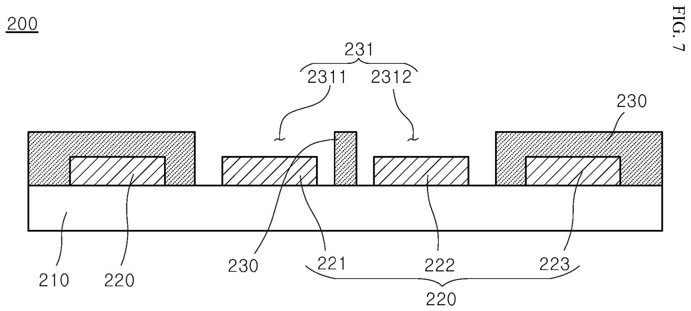

FIG. 7 is a cross-sectional view of the protection circuit module according to embodiments of the present disclosure taken along line A-A' shown in FIG. 5.

A protection circuit module 200 according to embodiments of the present disclosure (for example, including the protection circuit module described in FIGS. 1 to 5) includes a substrate 210, a circuit pattern 220 disposed on the substrate 210, and an insulating layer 230 disposed on the substrate 210 while covering the circuit pattern 220, and the insulating layer 230 includes one or more holes 231 formed on at least a portion of the circuit pattern 220.

For example, the circuit pattern 220 includes heating patterns (for example, 221 and 222) and a normal pattern (for example, 223). For example, the heating pattern includes a first heating pattern 221 and a second heating pattern 222.

As shown in FIG. 6, for example, the hole 231 is formed to correspond to two or more heating patterns (for example, 221 and 222). For example, one hole 231 may be formed on the first heating pattern 221 and the second heating pattern 222. Thus, when two or more heating patterns (for example, 221 and 222) are located adjacent to each other, one hole 231 may be formed while opening the two or more heating patterns (for example, 221 and 222).

For example, two or more heating patterns (for example, 221 and 222) may be disposed adjacent to each other within a preset distance. In this case, the preset distance is a distance which is narrow enough to prevent the insulating layer 230 from being formed, and may be set differently depending on the height/material of the insulating layer 230. In this case, when the heating patterns (for example, 221 and 222) are disposed adjacent to each other, the hole 231 may be formed on the two or more heating patterns (for example, 221 and 222).

Accordingly, the hole 231 allows heat generated from the heating patterns (for example, 221 and 222) to be more effectively discharged.

Alternatively, as shown in FIG. 7, for example, a hole 231 is formed to correspond to each of two or more heating patterns. For example, one hole 231 is formed on one heating pattern (for example, 221 or 222). For example, a first hole 2311 may be formed on the first heating pattern 221. For example, a second hole 2312 may be formed on the second heating pattern 222. That is, the insulating layer 230 may be located between the first heating pattern 221 and the second heating pattern 222.

For example, two or more heating patterns (for example, 221 and 222) may not be disposed adjacent to each other. Alternatively, for example, a short circuit between the two or more heating patterns (for example, 221 and 222) may easily occur. In this case, when the insulating layer 230 is essentially required between the heating patterns (for example, 221 and 222), the hole 231 may be formed to correspond to each of the heating patterns (for example, 221 and 222).

Accordingly, the holes 231 help heat dissipation of the heating patterns (for example, 221 and 222). Further, the insulating layer 230 not only insulates between the circuit patterns 220 and the outside, but also insulates between the circuit patterns 220

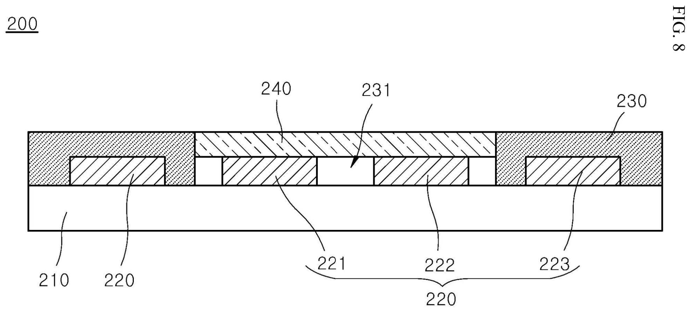

FIG. 8 is a cross-sectional view of the protection circuit module according to embodiments of the present disclosure taken along line A-A' shown in FIG. 5.

A protection circuit module 200 according to embodiments of the present disclosure (for example, including the protection circuit module described in FIGS. 1 to 7) includes a substrate 210, a circuit pattern 220 disposed on the substrate 210, and an insulating layer 230 disposed on the substrate 210 while covering the circuit pattern 220, and the insulating layer 230 includes one or more holes 231 formed on at least a portion of the circuit pattern 220.

The protection circuit module 200 may further include an upper insulating layer 240 which includes an insulating material and covers at least a portion of the hole 231.

The upper insulating layer 240 includes an insulating material. For example, the upper insulating layer 240 may include the same material as the insulating layer 230.

Alternatively, for example, the insulating material may include at least one selected from the group consisting of polyimide (PI), polysulfone, polyurethane (PU), polyamide (PA), 6,6 nylon, polycarbonate (PC), polytetrafluoroethylene (PTFE), polymethyl methacrylate (PMMA), and polyethylene terephthalate (PET).

The upper insulating layer 240 covers all or part of the hole 231.

For example, as shown in FIG. 8, the upper insulating layer 240 may cover the entire hole 231. Accordingly, the upper insulating layer 240 may insulate the heating patterns (for example, 221 and 222) from the outside.

Alternatively, for example, unlike as shown in FIG. 8, the upper insulating layer 240 may cover a portion of the hole 231. Accordingly, the upper insulating layer 240 may insulate the heating patterns (for example, 221 and 222) from the outside while allowing the heating patterns (for example, 221 and 222) to dissipate heat.

For example, the upper insulating layer 240 is located on the circuit pattern 220 exposed by the hole 231 and at least a portion of the upper insulating layer 240 is provided to be spaced a certain distance apart from the substrate 210.

For example, at least a portion of the upper insulating layer 240 which covers the hole 231 is located to be spaced apart from the substrate 210. For example, the entire upper insulating layer 240 is located to be spaced apart from the substrate 210. Alternatively, for example, a portion of the upper insulating layer 240 is located to be spaced apart from the substrate 210. For example, the upper insulating layer 240 may be formed to be spaced apart from the substrate 210 by a distance equal to or greater than a thickness of the circuit pattern 220. Alternatively, for example, the upper insulating layer 240 may be formed to be spaced apart from the substrate 210 by a distance equal to or less than the thickness of the circuit pattern 220 and may fill at least a portion of a space between the circuit pattern 220, the substrate 210, and the upper insulating layer 240.

That is, the upper insulating layer 240 may be disposed so that a space is formed around the circuit pattern 220 by the upper insulating layer 240, the substrate 210, and the circuit pattern 220. Alternatively, the upper insulating layer 240 may be disposed so that a space is formed around the circuit pattern 220 by the upper insulating layer 240, the substrate 210, the circuit pattern 220, and the insulating layer 230.

This space provides a region where heat may be discharged from the circuit pattern 220. For example, this space allows the heat generated from the circuit pattern 220 to be dissipated. Accordingly, the protection circuit module 200 allows the hole 231 to dissipate the heat generated from the circuit pattern 220 even when at least a portion of the hole 231 is covered by the upper insulating layer 240.

Meanwhile, as shown in FIG. 6, the hole 231 may be formed to correspond to two or more heating patterns (for example, 221 and 222).

As shown in FIG. 8, the upper insulating layer 240 may be formed while covering the holes 231. For example, the upper insulating layer 240 may be formed while covering upper portions of the holes 231. In this way, the upper insulating layer 240 may cover the holes 231 while forming the widest space possible with the substrate 210. Accordingly, the upper insulating layer 240 may form a wide space capable of dissipating heat. Furthermore, the protection circuit module 200 may enhance the heat dissipation efficiency while insulating the circuit pattern 220

Alternatively, unlike as shown in FIG. 8, the upper insulating layer 240 may cover the upper portion of the hole 231 while being formed on at least a portion between the two or more heating patterns (for example, 221 and 222). For example, the upper insulating layer 240 may cover the upper portion of the hole 231 while forming a partition between the first heating pattern 221 and the second heating pattern 222. In this case, the partition may be formed between the heating patterns (for example, 221 and 222) without coming into contact with each of the heating patterns (for example, 221 and 222). Accordingly, the upper insulating layer 240 may form a space capable of dissipating heat while insulating the heating patterns (for example, 221 and 222) from each other. Further, the protection circuit module 200 may enhance the insulation efficiency while allowing the circuit pattern 220 to dissipate heat.

In FIGS. 5 to 8, an example in which the protection circuit module 200 according to embodiments of the present disclosure performs heat dissipation by exposing an upper portion of the circuit pattern 220 through the hole 231 was described. Hereinafter, an example in which the protection circuit module 200 performs heat dissipation by exposing a side of the circuit pattern 220 through an opening will be described in detail.

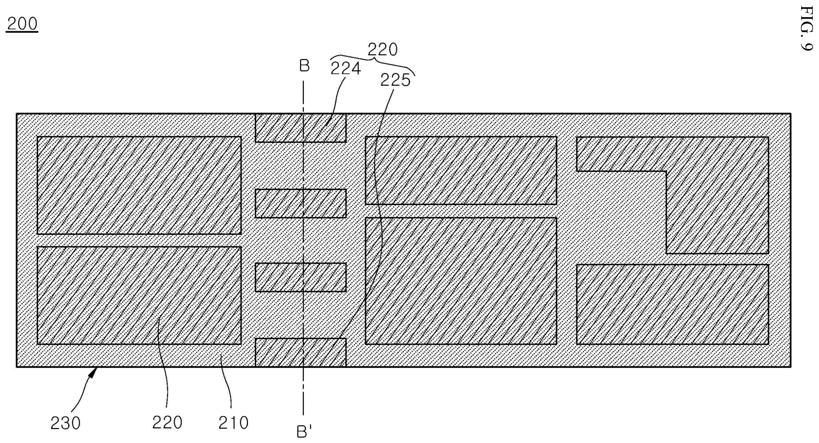

FIG. 9 is a top view schematically illustrating a protection circuit module according to embodiments of the present disclosure.

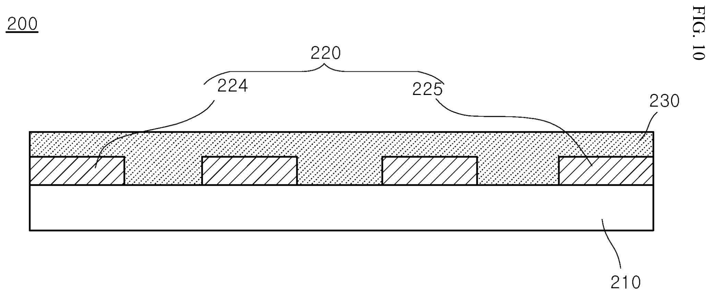

FIG. 10 is a cross-sectional view of the protection circuit module according to embodiments of the present disclosure taken along line B-B' shown in FIG. 9.

A protection circuit module 200 according to embodiments of the present disclosure (for example, including the protection circuit module 200 described in FIGS. 1 to 8) may protect and/or control all or part of the components included in a battery pack 1000 (for example, including the battery pack described in FIGS. 1 to 8). For example, the protection circuit module 200 may control the charging and discharging of the secondary battery 100 and may detect and/or prevent the overcharging and/or overdischarging of the secondary battery 100.

As described in FIGS. 1 to 8, in the protection circuit module 200, an upper portion of the circuit pattern 220 may be exposed through the hole 231. However, when the size of the protection circuit module 200 is small, it may be difficult to form the hole 231 in the insulating layer 230. In this case, the protection circuit module 200 is required to have a structure having a heat dissipation effect without forming the hole 231.

The protection circuit module 200 includes a substrate 210, a circuit pattern 220 disposed on the substrate 210, and an insulating layer 230 disposed on the substrate 210 while covering the circuit pattern 220, and the insulating layer 230 includes an opening formed on at least a portion of a side of the circuit pattern 220.

The battery pack 1000 includes a plurality of secondary batteries 100, and a protection circuit module 200 disposed on one side of the plurality of secondary batteries 100 and electrically connected to the plurality of secondary batteries 100, the protection circuit module 200 includes a substrate 210, a circuit pattern 220 disposed on the substrate 210, and an insulating layer 230 disposed on the substrate 210 while covering the circuit pattern 220, and the insulating layer 230 includes an opening formed on at least a portion of the side of the circuit pattern 220.

As described in FIGS. 3 and 4, the insulating layer 230 includes an opening which exposes at least a portion of the circuit pattern 220.

For example, the insulating layer 230 is formed by being applied and/or coated on the substrate 210 on which the circuit pattern 220 is disposed. In this case, the insulating layer 230 may not be applied and/or coated on at least a portion of the side of the circuit pattern 220. The opening represents a region where the insulating layer 230 is not applied or coated. The opening exposes a portion of the side of the circuit pattern 220.

Accordingly, a portion of the circuit pattern 220 may be exposed through the opening, and the other portion of the circuit pattern 220 may be covered by the insulating layer 230.

For example, the opening is formed for heating patterns (for example, 224 and 225) which generate more than a certain amount of heat per unit time in the circuit pattern 220. In this case, the certain amount of heat per unit time may be set in consideration of the material/thickness of the insulating layer 230, the material/thickness of the housing 1100, the capacity/size of the battery pack 1000, the capacity/size of the secondary battery 100, and the like. For example, the heating patterns (for example, 224 and 225) include a circuit pattern (for example, 220) which conducts a current through a power line and is related to heating performance due to resistance. For example, the heating patterns (for example, 224 and 225) may include at least one of a field effect transistor (FET), a synchronous rectifier (SR), a resistor, a capacitor, and a transistor. Alternatively, for example, the heating patterns (for example, 224 and 225) may include a high current pattern formed along a line through which a high current flows.

For example, at least portions of the heating patterns (for example, 224 and 225) are disposed along an edge of the substrate 210. For example, the heating pattern (for example, 224 or 225) may be disposed so that one side is located at the edge of the substrate 210. However, the disposition of the heating patterns (for example, 224 and 225) shown in FIG. 9 is only an example, and the disposition, size, and/or shape of the circuit pattern 220 according to embodiments of the present disclosure are not limited thereto.

For example, the heating pattern may be disposed so that one side or two or more sides are located along the edge of the substrate 210. Alternatively, for example, the protection circuit module 200 may include one heating pattern, and the one heating pattern may be formed to have the same size as the substrate 210 when viewed from above. Thus, the heating pattern may have any shape, size, and/or disposition in which a side is easily exposed by the opening and may be disposed on the substrate 210.

For example, the opening exposes at least portions of the sides of the heating patterns (for example, 224 and 225). Accordingly, when viewed from the side, the heating patterns (for example, 224 and 225) are at least partially exposed by the opening.

For example, as shown in FIGS. 9 and 10, the opening may allow one side of one heating pattern (for example, 224 or 225) to be completely exposed. Accordingly, the insulating layer 230 may efficiently discharge heat generated from the circuit pattern 220 through the opening.

However, unlike as shown in FIGS. 9 and 10, the opening may expose a portion of one side of one heating pattern (for example, 224 or 225).

For example, the heating pattern includes a fourth heating pattern 224 and a fifth heating pattern 225. In this case, for example, a heat generation amount of the fifth heating pattern 225 may be greater than that of the fourth heating pattern 224.

For example, the opening may be formed on a portion of a side of the fourth heating pattern 224. That is, a portion of one side of the fourth heating pattern 224 may be exposed to the outside by the opening and the other portion of the one side of the fourth heating pattern 224 may be covered by the insulating layer 230. Thus, the opening may simultaneously perform insulation and/or heat dissipation of the circuit pattern 220 by exposing only a portion of the circuit pattern 220 having a relatively small heat generation amount.

For example, the opening may be formed on the entire one side of the fifth heating pattern 225. That is, the entire one side of the fifth heating pattern 225 may be exposed to the outside by the opening. Thus, the opening may enhance the heat dissipation efficiency of the circuit pattern 220 by exposing the entire circuit pattern 220 having a relatively large heat generation amount.

Thus, the insulating layer 230 may include an opening whose position and/or size are/is set by predicting the heat generation amount of the heating patterns (for example, 224 and 225).

In this case, as described in FIGS. 3 and 4, the substrate 210 may include short and long sides. For example, at least portions of the heating patterns (for example, 224 and 225) may be disposed along edges of the long sides of the substrate 210. Alternatively, for example, portions of the heating patterns (for example, 224 and 225) may be disposed along the edges of the long sides of the substrate 210 and other portions of the heating patterns (for example, 224 and 225) may be disposed along edges of the short sides of the substrate 210. Accordingly, the protection circuit module 200 may further maximize the heat dissipation efficiency.

Further, in the circuit pattern 220, normal patterns other than the heating patterns (for example, 224 and 225) may be disposed in a central portion of the substrate 210. Accordingly, the normal patterns may be covered and insulated by the insulating layer 230. However, in the circuit pattern 220, both the heat dissipation patterns (for example, 224 and 225) and the normal patterns may be disposed along the edges of the substrate 210.

Thus, the protection circuit module 200 according to embodiments of the present disclosure may have a heat dissipation structure through the opening formed in at least a portion of the insulating layer 230. Further, the battery pack 1000 may reduce the maximum temperature when heat is generated by the protection circuit module 200.

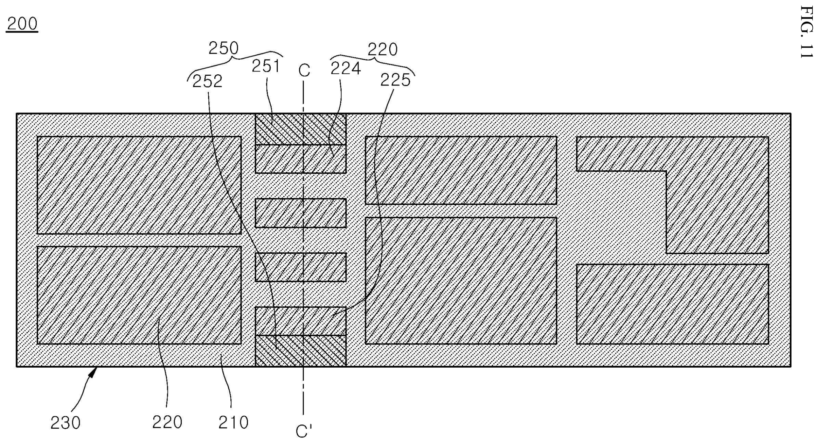

FIG. 11 is a top view schematically illustrating a protection circuit module according to embodiments of the present disclosure.

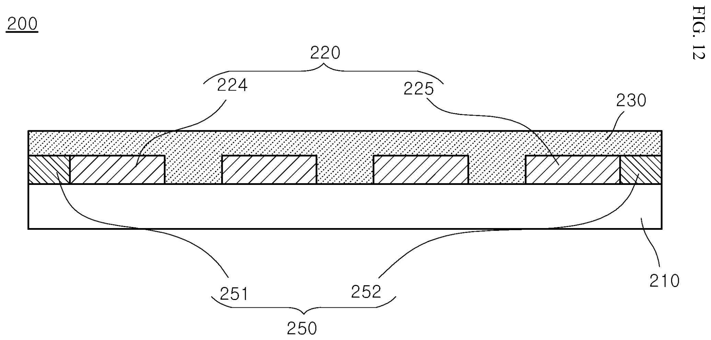

FIG. 12 is a cross-sectional view of the protection circuit module according to embodiments of the present disclosure taken along line C-C' shown in FIG. 11.

As described in FIGS. 1 to 8, in the protection circuit module 200, an upper portion of the circuit pattern 220 may be exposed through the hole 231. However, when the size of the protection circuit module 200 is small, it may be difficult to form the hole 231 in the insulating layer 230. In this case, the protection circuit module 200 is required to have a structure having a heat dissipation effect without forming the hole 231.

A protection circuit module 200 according to embodiments of the present disclosure (for example, including the protection circuit module 200 described in FIGS. 1 to 10) includes a substrate 210, a circuit pattern 220 disposed on the substrate 210, and an insulating layer 230 disposed on the substrate 210 while covering the circuit pattern 220, and the insulating layer 230 includes an opening formed on at least a portion of a side of the circuit pattern 220.

For example, at least a portion of the heating pattern (for example, 224 or 225) is disposed to be spaced a certain distance apart from the edge of the substrate 210. That is, one side of the heating pattern (for example, 224 and 225) may not coincide with the edge of the substrate 210.

For example, the protection circuit module 200 further includes plating layers 250 which are disposed along the edges of the substrate 210 and come into contact with at least portions of the heating patterns (for example, 224 and 225). For example, the plating layer 250 may be formed between one side of the heating pattern (for example, 224 or 225) and the edge of the substrate 210.

For example, the heating patterns may include a fourth heating pattern 224 disposed adjacent to the edge of one side of the substrate 210 and a fifth heating pattern 225 disposed adjacent to the edge of the other side of the substrate 210.

For example, the plating layers 250 may include a first plating layer 251 disposed along the edge of one side of the substrate 210 and disposed adjacent to the fourth heating pattern 224, and a second plating layer 252 disposed along the edge of the other side of the substrate 210 and disposed adjacent to the fifth heating pattern 225.

In this case, the plating layers 250 may be in contact with the heating patterns (for example, 224 and 225). Alternatively, the plating layers 250 may be spaced apart from the heating patterns (for example, 224 and 225).

In this case, the plating layer 250 may include a conductive material. For example, the plating layer 250 may include the same material as the heating patterns (for example, 224 and 225). Alternatively, for example, the plating layer 250 may include a conductive metal such as copper (Cu), aluminum (Al), iron (Fe), tungsten (W), gold (Au), silver (Ag), and the like. Alternatively, for example, the plating layer 250 may include a conductive polymer. Alternatively, the plating layer 250 may include a metal and a conductive polymer.

For example, the opening exposes a side of the plating layer 250. Accordingly, the heat generated from the heating patterns (for example, 224 and 225) may be conducted by the plating layers 250 and discharged through the opening.

In this case, the opening may be formed on all or part of the side of the plating layer 250. Accordingly, a portion of the side of the plating layer 250 may be covered by the insulating layer 230. Accordingly, the insulating layer 230 may insulate the plating layer 250 while allowing the plating layer 250 to dissipate heat.

Through this structure, the protection circuit module 200 according to embodiments of the present disclosure may provide a method of dissipating heat to the outside by extending the circuit pattern 220 even when the circuit pattern 220 is not disposed along the edge of the substrate 210.

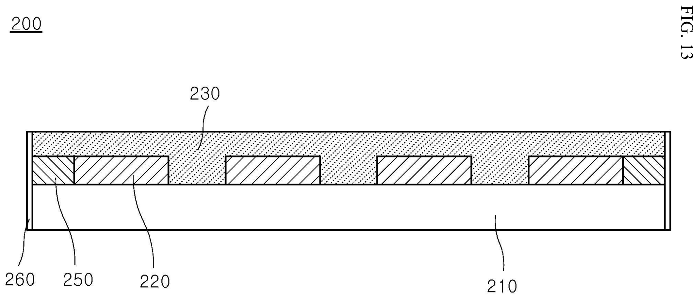

FIG. 13 is a cross-sectional view of the protection circuit module according to embodiments of the present disclosure taken along line C-C' shown in FIG. 11.

A protection circuit module 200 according to embodiments of the present disclosure (for example, including the protection circuit module 200 described in FIGS. 1 to 12) includes a substrate 210, a circuit pattern 220 disposed on the substrate 210, and an insulating layer 230 disposed on the substrate 210 while covering the circuit pattern 220, and the insulating layer 230 includes an opening formed on at least a portion of a side of the circuit pattern 220.

For example, the protection circuit module 200 may further include a side insulating layer 260 including an insulating material and provided in the opening to cover the exposed circuit pattern 220.

For example, the side insulating layer 260 may include Nomex tape, a plastic case, or the like. Alternatively, for example, the side insulating layer 260 may include the same material as the insulating layer 230.

Alternatively, for example, the side insulating layer 260 includes an insulating material.

For example, the insulating material may include at least one selected from the group consisting of polyimide (PI), polysulfone, polyurethane (PU), polyamide (PA), 6,6 nylon, polycarbonate (PC), polytetrafluoroethylene (PTFE), polymethyl methacrylate (PMMA), and polyethylene terephthalate (PET).

The side insulating layer 260 covers all or part of the opening.

For example, as shown in FIG. 13, when the protection circuit module 200 includes the plating layers 250, the side insulating layer 260 may cover all or part of the opening while covering all or part of the plating layer 250.

Alternatively, for example, unlike as shown in FIG. 13, when the protection circuit module 200 does not include the plating layers 250, the side insulating layers 260 may cover all or part of the opening while covering the heating patterns (for example, 224 and 225). In this case, the side insulating layers 260 may be in contact with at least portions of the heating patterns (for example, 224 and 225). Alternatively, the side insulating layers 260 may be spaced apart from at least portions of the heating patterns (for example, 224 and 225). Accordingly, the side insulating layer 260 may insulate the circuit pattern 220 from the outside.

Through this structure, the protection circuit module 200 according to embodiments of the present disclosure may provide a method of simultaneously performing heat dissipation and insulation.

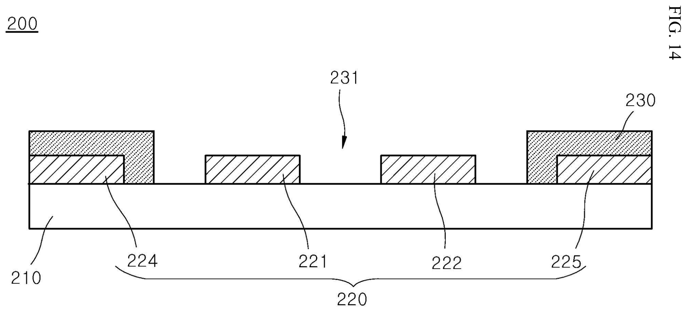

FIG. 14 is a cross-sectional view of a protection circuit module according to embodiments of the present disclosure.

A protection circuit module 200 according to embodiments of the present disclosure (for example, including the protection circuit module described in FIGS. 1 to 13) includes a substrate 210, a circuit pattern 220 disposed on the substrate 210, and an insulating layer 230 disposed on the substrate 210 while covering the circuit pattern 220, and the insulating layer 230 includes one or more holes 231 formed on at least a portion of the circuit pattern 220, and an opening formed on at least a portion of a side of the circuit pattern 220.

Further, a battery pack 1000 according to embodiments of the present disclosure (for example, including the battery pack described in FIGS. 1 to 13) includes a plurality of secondary batteries 100, and a protection circuit module 200 disposed on one side of the plurality of secondary batteries 100 and electrically connected to the plurality of secondary batteries 100, the protection circuit module 200 includes a substrate 210, a circuit pattern 220 disposed on the substrate 210, and an insulating layer 230 disposed on the substrate 210 while covering the circuit pattern 220, and the insulating layer 230 includes one or more holes 231 formed on at least a portion of the circuit pattern 220, and an opening formed on at least a portion of a side of the circuit pattern 220.

For example, the hole 231 includes the hole 231 described in FIGS. 5 to 8. The hole 231 exposes at least a portion of the circuit pattern 220 toward the top. For example, the hole 231 may expose the circuit patterns (for example, 221 and 222) located in the central portion of the substrate 210.

For example, the opening includes the opening described in FIGS. 9 to 13. The opening exposes at least a portion of a side of the circuit pattern 220. For example, the opening may expose the circuit patterns (for example, 224 and 225) located along the edge of the substrate 210.

Thus, the protection circuit module 200 may more effectively dissipate heat generated from the circuit pattern 220 by including both the hole 231 and the opening.

In this case, the protection circuit module 200 may further include an upper insulating layer (for example, including the upper insulating layer described in FIG. 8) which covers at least a portion of the hole 231.

In this case, the protection circuit module 200 may further include side insulating layers (for example, including the side insulating layers described in FIG. 13) which cover at least a portion of the opening.

Through this structure, the protection circuit module 200 according to embodiments of the present disclosure may perform heat dissipation without including separate components for dissipating heat. Further, the battery pack 1000 according to embodiments of the present disclosure may provide a structure in which a maximum temperature is reduced and stability is enhanced even when heat is generated.

According to the present disclosure, a protection circuit module whose maximum temperature is reduced and/or a battery pack including the protection circuit module can be provided.

According to the present disclosure, a protection circuit module whose stability is enhanced and/or a battery pack including the protection circuit module can be provided.

However, technical effects acquirable through the present disclosure are not limited to the herein-described technical effects, and other technical effects which are not mentioned will be clearly understood by those skilled in the art from the description of the disclosure described herein.

Although the present disclosure has been described with reference to the embodiments shown in the drawings, these are merely exemplary, and it should be understood by those skill in the art that various modifications and equivalents are possible.

Accordingly, the technical scope of the present disclosure should be defined by the following claims.

## Claims

1. A protection circuit module (200) comprising:
a substrate (210);
a circuit pattern (220) disposed on the substrate (210); and
an insulating layer (230) provided on the substrate (210) while covering the circuit pattern (220),
wherein the insulating layer (230) includes one or more holes (231) formed on at least a portion of the circuit pattern (220).

2. The protection circuit module (200) of claim 1, wherein the hole (231) exposes an upper portion of at least a portion of the circuit pattern (220),
wherein the hole (231) is formed on a heating pattern (221, 222) that generates a certain amount of heat or more per unit time in the circuit pattern (220).

3. The protection circuit module (200) of claim 2, wherein the heating pattern (221, 222) includes at least one of a field effect transistor, FET, a synchronous rectifier (SR), a resistor, a capacitor, a transistor, and a high current pattern.

4. The protection circuit module (200) of claim 2 or 3, comprising two or more heating patterns (221, 222),
wherein the hole (231) is formed to correspond to each of the two or more heating patterns (221, 222).

5. The protection circuit module (200) of any one of the preceding claims, further comprising an upper insulating layer (240) that includes an insulating material and covers at least a portion of the hole (231),
wherein the upper insulating layer (240) is located on the circuit pattern (220) exposed by the hole (231) and is provided to be spaced a certain distance from the substrate (210).

6. The protection circuit module (200) of any one of the preceding claims, wherein the insulating layer (230) includes an opening formed on a side of at least another portion of the circuit pattern (220),
wherein the opening exposes a side of at least another portion of the circuit pattern (220).

7. The protection circuit module (200) of claim 6, wherein the at least another portion of the circuit pattern (220) is disposed to be spaced a certain distance from an edge of the substrate (210).

8. The protection circuit module (200) of claim 7, further comprising a plating layer (250) that is disposed along an edge of the substrate (210) and comes into contact with at least a portion of the heating pattern (221, 222),
wherein the opening exposes a side of the plating layer (250).

9. A battery pack (1000) comprising:
a plurality of secondary batteries (100); and
a protection circuit module (200) disposed on one side of the plurality of secondary batteries (100) and electrically connected to the plurality of secondary batteries (100),
wherein the protection circuit module (200) includes:
a substrate (210);
a circuit pattern (220) disposed on the substrate (210); and
an insulating layer (230) provided on the substrate (210) while covering the circuit pattern (220), and
wherein the insulating layer (230) includes one or more holes (231) formed on at least a portion of the circuit pattern (220).

10. The battery pack (1000) of claim 9, wherein the hole (231) exposes an upper portion of at least a portion of the circuit pattern (220),
wherein the hole (231) is formed on a heating pattern (221, 222) that generates a certain amount of heat or more per unit time in the circuit pattern (220).

11. The battery pack (1000) of claim 10, wherein:
the protection circuit module (200) includes two or more heating patterns (221, 222); and
the hole (231) is formed to correspond to each of the two or more heating patterns (221, 222).

12. The battery pack (1000) of claim 10 or 11, wherein:
the protection circuit module (200) includes two or more heating patterns (221, 222); and
the hole (231) is formed to correspond to the two or more heating patterns (221, 222).

13. The battery pack (1000) of any one of the claims 9 to 12, wherein the protection circuit module (200) further includes an upper insulating layer (240) that includes an insulating material and covers at least a portion of the hole (231).

14. The battery pack (1000) of claim 13, wherein the upper insulating layer (240) is located on the circuit pattern (220) exposed by the hole (231) and is provided to be spaced a certain distance from the substrate (210).
